# EUROPÄISCHE PATENTSCHRIFT

(11) **EP 2 680 333 B1**
(45) Veröffentlichungstag und Bekanntmachung des Hinweises auf die Patenterteilung: **07.01.2015**
(21) Anmeldenummer: 13171785.2
(22) Anmeldetag: 13.06.2013
(51) Int. Cl.: H01L 39/14

(54) **NbTi-Supraleiter mit in Umfangsrichtung verteilten AI-Blöcken zur Gewichtsreduzierung**
NbTi superconductor with circumferentially distributed AI blocks for weight reduction
Supraconducteur NbTi comprenant des blocs Al répartis sur la circonférence pour la réduction du poids

(30) Priorität: 25.06.2012 DE 102012210770
(43) Veröffentlichungstag der Anmeldung: 01.01.2014
(73) Patentinhaber: Bruker EAS GmbH, 63450 Hanau (DE)
(72) Erfinder: Szulczyk, Andreas, 63589 Linsengericht (DE)
(74) Vertreter: Kohler Schmid Möbus

(56) Entgegenhaltungen:
- EP-A1- 0 067 591
- JP-A- H03 192 611
- JP-A- H06 203 653

## Beschreibung

Die Erfindung betrifft einen Supraleiterdraht, enthaltend NbTi-Supraleitermaterial und Cu.

Niobtitan (NbTi) ist ein wichtiges Supraleitermaterial, welches aufgrund seiner guten plastischen Verformbarkeit (sowohl im Fertigmaterial als auch bezüglich Precursoren) vielseitig eingesetzt werden kann, beispielsweise in supraleitenden Magnetspulen oder supraleitenden Kabeln. Das NbTi-Supraleitermaterial ist dabei typischerweise in einen Supraleiterdraht integriert, wobei meist eine Vielzahl von NbTi-Filamenten entlang der Erstreckungsrichtung des Supraleiterdrahtes verlaufen.

Im Rahmen der Drahtherstellung ist es oftmals vorgesehen, zur Vereinfachung von Bündelungsprozessen bei NbTi-Einzelfilamenten (oder auch anderen Strukturen und Zwischenstrukturen) zunächst im Rahmen eines Ziehprozesses eine plastische Verformung zu einem hexagonalen Außenquerschnitt vorzunehmen. Die entstehenden Hexagonalelemente können dann sehr kompakt beispielsweise in einem Cu-Hüllrohr angeordnet werden, vgl. die eingangs erwähnte US 5,088,183 A.

Die supraleitenden Eigenschaften von NbTi werden nur bei besonders tiefer Temperatur, unterhalb von ca. 9 K, erreicht, so dass der Supraleiter gekühlt werden muss, etwa mit flüssigem Helium. Ebenso wird der supraleitende Zustand bei zu hoher Magnetfeldstärke oder auch zu hoher Stromdichte nicht mehr aufrecht erhalten.

NbTi-Supraleiterdrähte sind typischerweise mit Kupfer (Cu), meist in hohen Reinheitsgraden, stabilisiert. Das Kupfer verlauft parallel zu supraleitenden Filamenten im Supraleiterdraht; beispielsweise kann das Kupfer eine Matrix für supraleitende NbTi-Filamente ausbilden. Das Kupfer stellt einen guten Wärmeleiter dar, über das eine effektive Kühlung der supraleitenden NbTi-Filamente erfolgen kann. Weiterhin hat das Kupfer eine hohe elektrische Leitfähigkeit. Im Falle eines lokalen Verlusts der Supraleitung im Supraleiterdraht stellt das Kupfer einen parallelen Strompfad zur Verfügung, wodurch ein Anstieg des elektrischen Widerstands und auch eine zugehörige Wärmeentwicklung begrenzt wird. Durch die effektive Kühlung kann der lokale normalleitende Bereich im Supraleiter schließlich wieder supraleitend werden (Stabilisierungsfunktion). Auch wenn eine Wiedergewinnung der Supraleitung nicht möglich ist, schützt das Kupfer vor einer Beschädigung ("Durchbrennen") des Supraleiters durch Begrenzung der Widerstandsanstiegs und dadurch Begrenzung der Wärmeentwicklung, und gleichzeitig effizienten Abtransport der entstehenden Wärme (Quenchschutz). Das Kupfer verbessert außerdem die mechanische Festigkeit des Supraleiterdrahts.

Kupfer ist zum einen ein teures Material, und zum anderen mit einer Dichte von ca. 8,9 g/cm³ relativ schwer, was bei vielen Anwendungen unerwünscht ist. Daher wird nach alternativen Materialien zur Stabilisierung von NbTi-Supraleitern gesucht, die das Kupfer zumindest teilweise ersetzen können. Aluminium (Al) in reiner Form wäre bezüglich Wärmeleitung und elektrischem Widerstand ein geeignetes Material, welches billiger als Kupfer und mit einer Dichte von 2,7 g/cm³ deutlich leichter ist.

In der WO 2008/121764 A1 wurde eine NbTi-Supraleiterstruktur mit einer Cu-Hülse, einem Al-Kern und ringförmig dazwischen angeordneten Multifilament-NbTi-Stäben vorgeschlagen.

Während Cu und NbTi beide relativ hart sind und sich bei plastischer Verformung ähnlich verhalten, ist Al im Vergleich zu NbTi und Cu deutlich weicher. Beim Drahtziehen wurden beim Einsatz von Al-Strukturen, insbesondere eines Al-Kerns, in einem NbTi-Supraleiterdraht Risse quer zur Erstreckungsrichtung des Drahtes beobachtet. Ein rissbehafteter Draht ist für Supraleiteranwendung unbrauchbar.

Aus der US 5,189,386 ist eine Supraleiterstruktur bekannt geworden, bei der ein Al-Kern durch Schichten aus einer Cu-Ni-Legierung in sechs Sektoren unterteilt ist. Diese Struktur ist relativ komplex.

In der US 4,652,697, die als nächstkommender Stand der Technik angesehen wird, ist eine Supraleiterstruktur beschrieben, bei der drei Al-Drähte und vier Multifilamentdrähte, beispielsweise mit NbTi-Filamenten und einer Kupfermatrix, gebündelt wurden. Einer der Multifilamentdrähte ist im Zentrum der Supraleiterstruktur angeordnet. Die Struktur wird von einem PbSn-Lot zusammengehalten. Ein Lot ist bei der Drahtherstellung schwierig zu verarbeiten und kann als weiteres Material die Rissbildungsproblematik zusätzlich verschärfen.

Die JP 09 282953 A beschreibt einen Nb₃Al-Supraleiterdraht, bei dem Nb₃Al-Filamente in eine Kupfermatrix eingebunden sind. Zur Verstärkung können eingebettete Zusatzstrukturen etwa aus Nb oder Ta vorgesehen sein. In einer Ausführungsform werden Zusatzstrukturen mit einem Al-Stab in einem Cu-Rohr vorgeschlagen.

Es wird ebenso Bezug auf den Stand der Technik in den Dokümenten JPH03192611, EP0067591 und JPH06203653 genommen

### Aufgabe derErfindung

Der Erfindung liegt die Aufgabe zugrunde, einen stabilisierten NbTi-Supraleiterdraht vorzuschlagen, der ein geringes Gewicht aufweist, wobei dessen Herstellung kostengünstig ist und wobei der Supraleiterdraht eine verringerte Neigung zur Rissbildung (insbesondere beim Drahtzeihen) hat.

### Kurze Beschreibung der Erfindung

Diese Aufgabe wird gelöst durch einen Supraleiterdraht, enthaltend NbTi-Supraleitermaterial und C gemäß dem Anspruch 1.

Im Rahmen der Erfindung wird im Supraleiterdraht zur Stabilisierung Kupfer teilweise durch Aluminium ersetzt, wobei mindestens drei Al-Blöcke vorgesehen sind. Die Al-Blöcke sind im Querschnitt des Drahtes (senkrecht zur Längsrichtung des Drahtes) in Umfangsrichtung verteilt angeordnet und durch NbTi-haltige Sektionen voneinander getrennt, d.h. Al-Blöcke und NbTi-haltige Sektionen alternieren in Umfangsrichtung. Die Al-Blöcke sind im Vergleich zu Kupfermaterial gleichen Volumens deutlich leichter und auch kostengünstiger. Insbesondere kann das Metergewicht (also die Masse des Supraleiterdrahtes pro Länge in Erstreckungsrichtung) gegenüber der ausschließlichen Verwendung von Kupfer zur Stabilisierung des Supraleitermaterials deutlich reduziert werden.

Durch einen erfindungsgemäß flächigen Kontakt zwischen den NbTi-haltigen Sektionen und den Al-Blöcken ist ein guter, unmittelbarer Wärme- und Stromübergang gewährleistet; typischerweise besteht der flächige Kontakt im Querschnitt über wenigstens 20% des Drahtdurchmessers an näherungsweise in radialer Richtung verlaufenden Grenzflächen von NbTi-haltigen Sektionen und Al-Blöcken. Dadurch wird zum einen eine sehr gute Stabilisierungsfunktion sichergestellt, zum anderen aber auch die Gesamtstruktur des Supraleiterdrahtes einfach gehalten.

Das Hüllrohr kann ebenfalls die Stabilisierung verbessern, insbesondere wenn dieses als Cu-Hüllrohr ausgebildet ist. Das Hüllrohr kann weiterhin die Al-Blöcke und die NbTi-haltigen Sektionen gut zusammenhalten.

Der erfindungsgemäße Supraleiterdraht ist lotfrei (insbesondere ohne ein PbSn-Lot) ausgebildet werden. Insbesondere wird kein Lot benötigt, um einen ausreichenden Wärmeleitungs- oder Stromleitungskontakt zwischen den Al-Blöcken und dem NbTi-Supraleitermaterial in den NbTi-haltigen Sektionen herzustellen; ebenso wird auch kein Lot benötigt, um die Gesamtstruktur des Supraleiterdrahtes zusammenzuhalten. Verunreinigungen des Supraleiterdrahts mit Fremdteilchen können im Rahmen der Erfindung sehr gering gehalten werden.

Die Al-Blöcke bestehen aus Aluminium-Vollmaterial, typischerweise mit einer Reinheit von 99 atom% oder höher. Die Querschnittsfläche eines erfindungsgemäßen Supraleiterdrahts hat typischerweise einen Anteil von wenigstens 10% Aluminium, bevorzugt wenigstens 20% Aluminium. Die NbTi-haltigen Sektionen sind bevorzugt nur aus Nb, Ti und Cu aufgebaut (von Dotierungen und Verunreinigungen unter 1 atom% abgesehen). Jede NbTi-haltige Sektion enthält mindestens ein, typischerweise jedoch eine Vielzahl von NbTi-Filamenten, die in Längsrichtung des Supraleiterdrahtes verlaufen. Kupfer(Cu)-Strukturen im Supraleiterdraht sind typischerweise ebenfalls von hoher Reinheit (bevorzugt > 99 atom% Cu); sie können aber auch mit einer kupferhaltigen Legierung ausgebildet sein (bevorzugt ≥ 80 atom% Cu, besonders bevorzugt ≥ 90 atom% Cu in der Cu-Legierung); dies gilt insbesondere für ein Cu-Hüllrohr, ein Cu-Profilrohr, Cu-Füllplatten und Cu-Blöcke (siehe unten).

Die Kontaktflächen zwischen den unterschiedlich verformbaren Materialen Aluminium einerseits sowie Kupfer und Niobtitan andererseits sind erfindungsgemäß auf wenigstens drei azimutal (in Umfangsrichtung) verteilte Al-Blöcke aufgeteilt. Dadurch ist ein mechanischer Spannungsaufbau bei der Umformung (etwa beim Drahtziehen) in Umfangsrichtung bezüglich des gesamten Supraleiterdrahtes entsprechend oft unterbrochen, was einer Rissbildung entgegenwirkt. Zum anderen reduziert die Ausbildung der Al-Blöcke aus Vollmaterial die Kontaktfläche zu Aluminium; Material im Inneren der Al-Blöcke nimmt kaum an einem Spannungsaufbau teil. Der erfindungsgemäße Aufbau hat sich in der Praxis als hoch resistent gegen Rissbildungen gezeigt. Insbesondere konnte mit einer geringen Zahl von azimutal verteilten Al-Blöcken (maximal sechs Al-Blöcken, bevorzugt drei oder vier Al-Blöcken), maximal einem zusätzlich, zentralen Al-Block (mit einem Durchmesser kleiner oder gleich 30% des Durchmessers des Supraleiterdrahts, bevorzugt kleiner oder gleich 25% des Durchmessers des Supraleiterdrahts) und typischerweise im Übrigen keinen weiteren Al-Strukturen im Supraleiterdraht sehr gute Ergebnisse erzielt werden.

Der erfindungsgemäße Supraleiterdraht insgesamt hat typischerweise einen näherungsweise kreisrunden Querschnitt, kann aber auch eine andere (äußere) Kontur haben, beispielsweise eine hexagonale Kontur.

Insgesamt kann mit der Erfindung ein gewichtsreduzierter NbTi-basierter Supraleiterdraht bereitgestellt werden, der bei geringen Fertigungskosten nur wenig Grenzfläche zwischen Al einerseits und Cu und NbTi andererseits bedingt, so dass ein günstiges, rissarmes Umformungsverhalten (insbesondere bei Extrusion und Ziehumformung) erhalten wird. Im Rahmen des Herstellungsprozesses ist die Gefahr einer Einbringung von Fremdteilchen zudem gering, was zum einen das Quenchrisiko verringert und zum anderen eine hohe Wärme- und Stromleitfähigkeit der Schutzstrukturen aus Al und Cu ermöglicht.

### Bevorzugte Ausführungsformen der Erfindung

Bei einer bevorzugten Ausführungsform des erfindungsgemäßen Supraleiterdrahts sind die NbTi-haltigen Sektionen durch einen oder mehrere tieflochgebohrte Cu-Blöcke ausgebildet, wobei NbTi-Strukturen, die jeweils ein oder mehrere NbTi-Filamente enthalten, in Bohrungen des einen oder der mehreren Cu-Blöcke eingefügt sind. Auf diese Weise können sehr einfach und kostengünstig NbTi-haltige Sektionen ausgebildet werden; der oder die Cu-Blöcke sind beim Herstellungsprozess einfach zu handhaben. Die Bohrungen und die zugehörigen NbTi-Strukturen weisen typischerweise einen runden Querschnitt auf. Der oder die Cu-Blöcke nehmen auch an der Stabilisierung der NbTi-Filamente teil (Kühlung/Ersatzstrompfade).

Bevorzugt ist eine Weiterbildung dieser Ausführungsform, bei der die NbTi-haltigen Sektionen durch nur einen tieflochgebohrten Cu-Block ausgebildet sind, wobei der Cu-Block wenigstens drei radial einwärts ausgebildete Nuten aufweist, die jeweils einen Al-Block enthalten. Diese Weiterbildung ist im Herstellungsprozess besonders einfach zu handhaben; in die Nuten des einen Cu-Blocks brauchen lediglich die Al-Blöcke eingelegt oder eingeschoben zu werden. Die Al-Blöcke werden dann durch den Cu-Block und das Hüllrohr sicher gehalten.

Bei einer alternativen Weiterbildung der obigen Ausführungsform ist vorgesehen, dass die NbTi-haltigen Sektionen jeweils durch einen tieflochgebohrten Cu-Block ausgebildet sind, und dass ein zentrales Cu-Profilrohr vorgesehen ist, an welches die Al-Blöcke und die Cu-Blöcke angrenzen, wobei das Profilrohr einen zusätzlichen Al-Block enthält. Über das Profilrohr und den zusätzlichen Al-Block kann der Anteil an Aluminium im Querschnitt weiter erhöht werden, und so das Gewicht des Supraleiterdrahts noch weiter reduziert werden.

Bevorzugt ist auch eine Ausführungsform, bei der die NbTi-haltigen Sektionen jeweils als ein Cluster von aneinander angrenzenden NbTi-Hexagonalelementen, welche jeweils ein oder mehrere NbTi-Filamente enthalten, ausgebildet sind. Dadurch können auf engem Raum sehr viele NbTi-Filamente eingesetzt werden; die Fertigung der NbTi-haltigen Sektionen kann leicht (über die Anzahl und Anordnung der gebündelten NbTi-Hexagonalelemente) an verschiedene Drahtgeometrien angepasst werden.

Vorteilhaft ist eine Weiterbildung dieser Ausführungsform, bei der ein zentrales Cu-Profilrohr vorgesehen ist, an welches die Al-Blöcke und die Cluster angrenzen, wobei das Profilrohr einen zusätzlichen Al-Block enthält, und wobei das Cu-Profilrohr eine äußere Profilierung geeignet für die Anlage der NbTi-Hexagonalelemente aufweist, insbesondere wobei das Cu-Profilrohr eine allseitige äußere Profilierung aufweist. Über das Profilrohr und den zusätzlichen Al-Block kann der Anteil an Aluminium im Querschnitt weiter erhöht werden, und so das Gewicht des Supraleiterdrahts noch weiter reduziert werden. Die Profilierungen gestatten eine dichte (spielarme oder sogar spielfreie) Packung der Strukturen des Supraleiterdrahts, insbesondere in dessen zentralem Bereich.

Bevorzugt ist auch eine Weiterbildung, bei der das Hüllrohr mehrere Cu-Füllplatten enthält, wobei die Cu-Füllplatten eine Profilierung geeignet für eine Anlage der NbTi-Hexagonalelemente der Cluster aufweisen. Die Füllplatten gestatten wiederum eine dichte (spielarme oder sogar spielfreie) Packung der Strukturen des Supraleiterdrahtes, insbesondere im Bereich der (typischerweise runden) Innenkontur des Hüllrohrs.

Ebenfalls bevorzugt ist eine Weiterbildung, bei der die Al-Blöcke eine Profilierung geeignet für die Anlage der NbTi-Hexagonalelemente der Cluster aufweisen, insbesondere wobei die Al-Blöcke eine allseitige Profilierung aufweisen. Die Profilierung gestattet wiederum eine dichte (spielarme oder sogar spielfreie) Packung der Strukturen der Anlageflächen zwischen den Al-Blöcken und den Clustern.

Besonders bevorzugt ist eine Ausführungsform des erfindungsgemäßen Supraleiterdrahts, die vorsieht, dass genau N Al-Blöcke vorgesehen sind, die in Umfangsrichtung verteilt im Hüllrohr angeordnet sind, und dass genau N NbTi-haltige Sektionen vorgesehen sind, die ebenfalls in Umfangsrichtung verteilt im Hüllrohr angeordnet sind, und die die Al-Blöcke in Umfangsrichtung voneinander trennen, wobei N = 3, 4, 5 oder 6. Dieser Anzahlbereich hat sich in der Praxis besonders bewährt; die gesamte Grenzfläche zwischen Al einerseits sowie Cu und NbTi andererseits bleibt begrenzt, da das Al auf vergleichsweise wenige Al-Blöcke verteilt ist.

Bei einer bevorzugten Ausführungsform ist schließlich vorgesehen, dass der Supraleiterdraht einen kreisrunden Querschnitt aufweist. Damit können Kraftspitzen auf den Supraleiterdraht - sei es im Betrieb oder auch bei Ziehprozessen - minimiert werden. Man beachte jedoch, dass auch andere Drahtquerschnitte, insbesondere ein hexagonaler Drahtquerschnitt, erfindungsgemäß möglich sind, gegebenenfalls wobei zunächst eine Fertigung des Supraleiterdrahts mit rundem Querschnitt erfolgt, und in einem nachfolgenden Ziehprozess der andere Drahtquerschnitt eingestellt wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Querschnittsansicht einer ersten Ausführungsform eines erfindungsgemäßen Supraleiterdrahts, mit drei Al-Blöcken und drei NbTi-haltigen Sektionen, die durch einen tieflochgebohrten Cu-Block ausgebildet werden;
- Fig. 2: eine schematische Querschnittsansicht einer zweiten Ausführungsform eines erfindungsgemäßen Supraleiterdrahts, mit drei Al-Blöcken und drei NbTi-haltigen Sektionen, die durch drei tieflochgebohrte Cu-Blöcke ausgebildet werden, und mit einem zusätzlichen zentralen Al-Block;
- Fig. 3: eine schematische Querschnittsansicht einer dritten Ausführungsform eines erfindungsgemäßen Supraleiterdrahts, mit drei Al-Blöcken und drei NbTi-haltigen Sektionen, die jeweils durch Cluster von NbTi-Hexagonalelementen ausgebildet werden, und mit einem zusätzlichen zentralen Al-Block.

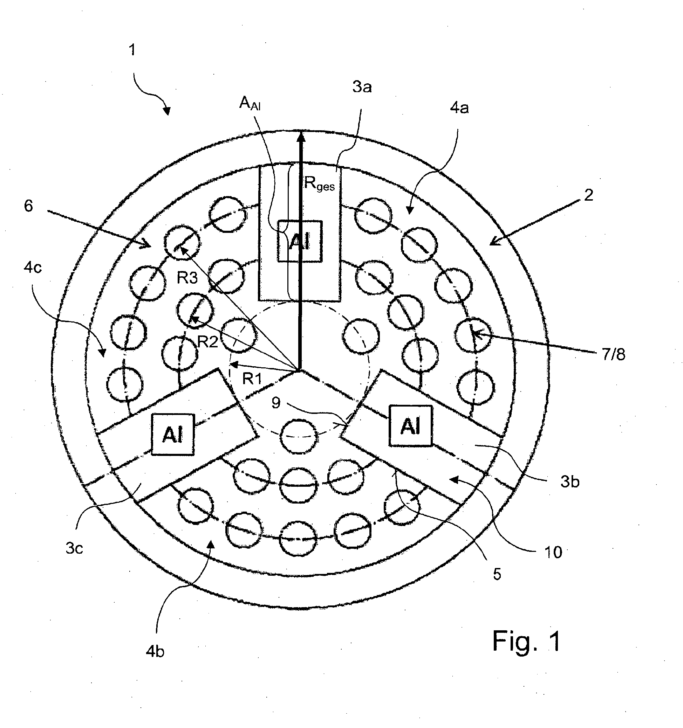

Die **Figur 1** illustriert eine erste Ausführungsform eines erfindungsgemäßen Supraleiterdrahts 1 in einem Querschnitt senkrecht zur Längsrichtung des Supraleiterdrahts 1. Der Supraleiterdraht 1 hat hier einen kreisrunden Querschnitt.

In einem Hüllrohr 2, hier einem Cu-Hüllrohr (mit wenigstens 80 atom% Cu-Anteil, bevorzugt wenigstens 99 atom% Cu-Anteil), sind mehrere (hier drei) Al-Blöcke 3a-3c aus hochreinem Aluminium (mit wenigstens 99 atom% Al-Anteil) azimutal (in Umfangsrichtung) gleichmäßig verteilt angeordnet, wobei hier die Al-Blöcke 3a-3c direkt an das Hüllrohr 2 angrenzen. Die Al-Blöcke 3a-3c werden azimutal von (hier ebenfalls drei) NbTi-haltigen Sektionen 4a-4c voneinander getrennt, die ebenfalls im Hüllrohr 2 angeordnet sind und hier ebenfalls direkt an das Hüllrohr 2 angrenzen.

Die NbTi-haltigen Sektionen 4a-4c grenzen direkt und flächig an die Al-Blöcke 3a-3c, vgl. die Grenzflächen 5. Insbesondere vermittelt kein Lot zwischen den Al-Blöcken 3a-3c und den NbTi-haltigen Sektionen 4a-4c. Der direkte, flächige Kontakt zwischen den Al-Blöcken 3a-3c und den NbTi-haligen Sektionen 4a-4c stellt einen guten Wärmeübergang und einen geringen elektrischen Widerstand sicher, so dass die Al-Blöcke 3a-3c sehr effizient zur Stabilisierung des Supraleitermaterials in den NbTi-haltigen Sektionen 4a-4c beitragen können.

Die NbTi-haltigen Sektionen 4a-4c werden hier durch einen einzigen Cu-Block 6 (mit wenigstens 80 atom% Cu-Anteil, bevorzugt wenigstens 99 atom% Cu-Anteil) ausgebildet, in dem eine Vielzahl von durchgehenden Bohrungen 7 ausgebildet sind (tieflochgebohrter Cu-Block). Die Bohrungen 7 sind jeweils mit einer NbTi-Struktur 8 befüllt. Jede NbTi-Struktur 8 enthält ein oder mehrere, sich in Längsrichtung des Supraleiterdrahts 1 (also senkrecht zur Zeichenebene der Fig. 1) erstreckende NbTi-Filamente (letztere sind nicht eingezeichnet). Die Bohrungen 7 sind in den NbTi-haltigen Sektionen 4a-4c azimutal gleichmäßig verteilt, hier auf drei Radien R1, R2, R3 (jeweils bezüglich der Bohrungsmittelpunkte).

Die näherungsweise in radialer Richtung verlaufenden Grenzflächen 5 zwischen den Al-Blöcken 3a-3c und den NbTi-haltigen Sektionen 4a-4c erstrecken sich über ca. 55% des Radius R_{ges} des Supraleiterdrahtes 1, vgl. Anteil A_{Al}. Etwa 15 % des Radius R_{ges} entfallen auf die Wandstärke des Hüllrohrs 2, und ca. 30% des Radius R_{ges} entfallen auf einen zentralen Bereich des Cu-Blocks 6. Im Allgemeinen ist es bevorzugt, wenn die Grenzflächen 5 sich in radialer Richtung wenigstens über 40% des Radius R_{ges} erstrecken (man beachte, dass die Grenzfläche 5 nicht exakt parallel zu einem Radiusvektor verlaufen braucht; ggf. kann die Grenzfläche auf einen Radiusvektor projiziert werden).

Das Zentrum des Supraleiterdrahts 1 wird in der Ausführungsform von Fig. 1 im Wesentlichen von Cu-Material des Cu-Blocks 6 eingenommen; zum Zentrum hin werden bilden die Al-Blöcke 3a-3c hier jeweils eine näherungsweise senkrecht zur Richtung eines Radiusvektors verlaufende, weitere Grenzfläche 9 aus.

Die Grenzflächen 5 und die weiteren Grenzflächen 9 begrenzen jeweils drei radial einwärts in den Cu-Block 6 gefräste Nuten 10, in die die Al-Blöcke 3a-3c eingefügt sind.

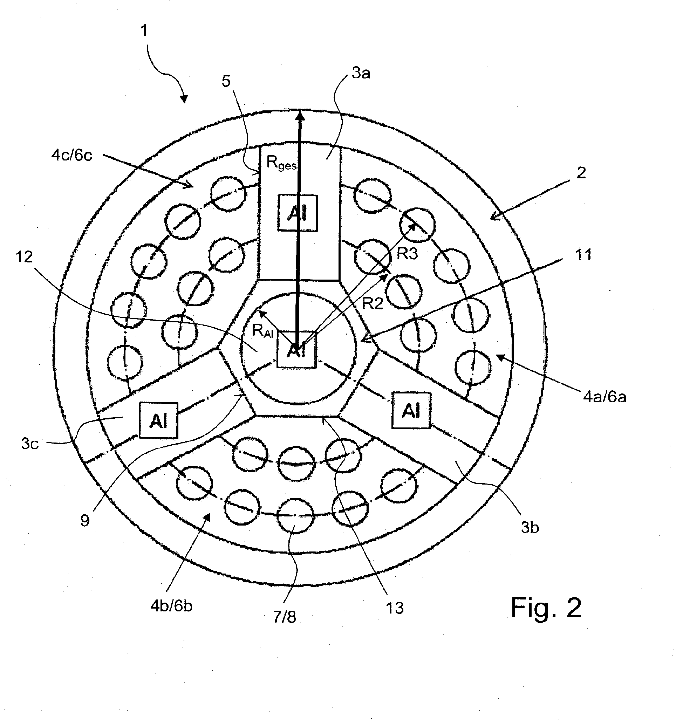

Die **Figur 2** illustriert eine zweite Ausführungsform eines erfindungsgemäßen Supraleiterdrahts 1 in einem Querschnitt senkrecht zur Längsrichtung des Supraleiterdrahts 1. Im Folgenden werden die wesentlichen Unterschiede zur Ausführungsform von Fig. 1 vorgestellt.

In dieser Ausführungsform sind die NbTi-haltigen Sektionen 4a, 4b, 4c jeweils durch einen eigenen, tieflochgebohrten Cu-Block 6a, 6b, 6c ausgebildet, d.h. es gibt hier drei Cu-Blöcke 6a-6c, entsprechend der Anzahl der NbTi-haltigen Sektionen 4a-4c. In den Bohrungen 7 der Cu-Blöcke 6a-6c ist jeweils eine NbTi-Sturktur 8 enthalten. Die Bohrungen 7 sind hier auf zwei Radien R2 und R3 azimutal gleichmäßig verteilt angeordnet. Die NbTi-haltigen Sektionen 4a-4c bzw. Cu-Blöcke 6a-6c separieren die Al-Blöcke 3a-3c in azimutaler Richtung, wobei die NbTi-haltigen Sektionen 4a-4c und die Al-Blöcke 3a-3c wiederum mit Grenzflächen 5 unmittelbar flächig aneinander grenzen. Dadurch ist ein guter Stabilisierungsbeitrag der Al-Blöcke 3a-3c gewährleistet.

Im Zentrum des Supraleiterdrahts 1 ist ein Cu-Profilrohr 11 angeordnet. In das Cu-Profilrohr 11 ist ein zusätzlicher, hier runder Al-Block 12 eingefügt; der Radius R_{Al} des zusätzlichen Al-Blocks 12 beträgt hier ungefähr 25% des Radius R_{ges} des Supraleiterdrahtes 1. Das Cu-Profilrohr 11 liegt außen an den Cu-Blöcken 6a-6c und den Al-Blöcken 3a-3c flächig an, vergleiche Grenzflächen 13 und 9. Die Innen- und Außenkontur des Cu-Profilrohrs 11 ist dabei an die Al-Blöcke 3a-3c, die Cu-Blöcke 6a-6c und den zusätzlichen Al-Block 12 angepasst, so dass keine Hohlräume zwischen den genannten Strukturen des Supraleiterdrahts 1 bleiben. Im gezeigten Ausführungsbeispiel weist das Cu-Profilrohr 11 dazu eine hexagonale Außenkontur auf. Die Al-Blöcke 3a-3c und die Cu-Bläcke 6a-6c liegen weiterhin mit runden Außenkonturen eng am Hüllrohr 2 an, so dass auch hier keine Hohlräume bleiben.

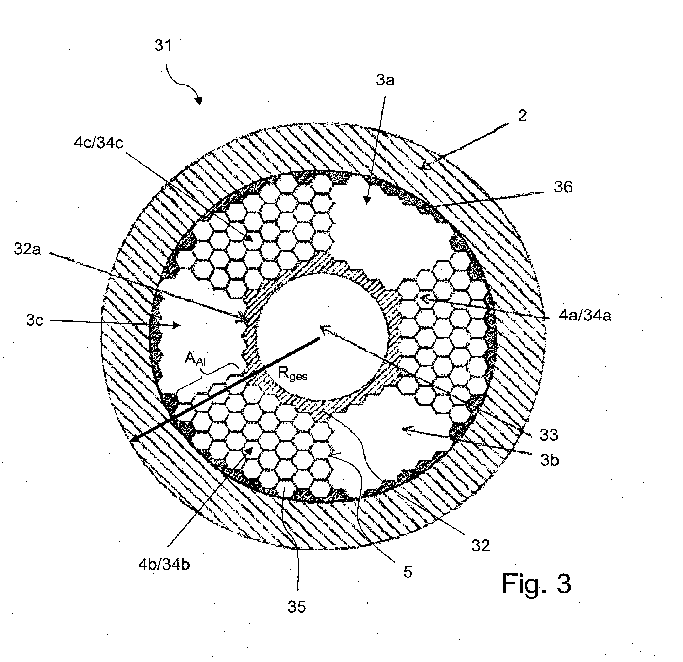

**Figur 3** zeigt eine dritte Ausführungsform eines erfindungsgemäßen Supraleiterdrahts 31, wiederum im Querschnitt senkrecht zu dessen Längserstreckung.

Der Supraleiterdraht 31 weist (ähnlich wie die Ausführungsform von Fig. 2) in einem Hüllrohr 2, nämlich einem Cu-Hüllrohr, drei Al-Blöcke 3a-3c auf, die in Umfangsrichtung alternierend mit drei NbTi-haltigen Sektionen 4a-4c angeordnet sind. Die NbTi-haltigen Sektionen 4a-4c werden jeweils durch einen Cluster 34a-34c von (im Querschnitt) aneinander grenzenden NbTi-Hexagonalelementen 35 ausgebildet. Jedes NbTi-Hexagonalelement 35 weist einen hexagonalen Querschnitt auf und enthält ein oder mehrere NbTi-Filamente (letztere nicht dargestellt), die in Längsrichtung des Supraleiterdrahts 31 (senkrecht zur Zeichenebene) verlaufen; jedes Cluster 34a-34c enthält hier sechsunddreißig NbTi-Hexagonalelemente 35.

Im Zentrum des Supraleiterdrahts 31 ist ein Cu-Profilrohr 32 angeordnet, welches nach außen hin nach einem hexagonalen Schema gezackt profiliert ist, vgl. die allseitige äußere Profilierung 32a. Im Inneren des Profilrohrs 32 ist ein zusätzlicher Al-Block 33 angeordnet.

An der Innenseite des Hüllrohrs 2 sind Cu-Füllplatten 36 angeordnet, die nach außen hin rund und nach innen hin in hexagonalem Schema gezackt profiliert sind. Weiterhin sind die Al-Blöcke 3a-3c (im Querschnitt) allseitig in hexagonalem Schema gezackt profiliert. Die Profilierungen der Cu-Füllplatten 36, des zentralen Cu-Profilrohrs 32 und der Al-Blöcke 3a-3c ermöglichen zusammen mit den Clustern 34a-34c eine insgesamt kompakte (insbesondere hohlraumfreie) und mechanisch stabile Gesamtstruktur des Supraleiterdrahts 1.

Die Al-Blöcke 3a-3c liegen im Bereich der gezackten Grenzflächen 5 zu den NbTi-haltigen Sektionen 4a-4c bzw. Clustern 34a-34c flächig an diesen an, wodurch wiederum ein guter Wärme- und Stromübergang gewährleistet ist; dadurch wird ein guter Stabilisierungsbeitrag der Al-Blöcke 3a-3c sichergestellt, wobei die Al-Blöcke 3a-3c weniger Gewicht zum Supraleiterdraht 1 beitragen als vergleichbare Cu-Strukturen gleichen Volumens. Die Grenzflächen 5 erstrecken sich hier in Radiusrichtung über ca. 40% des Radius R_{ges} des Supraleiterdrahtes 1, vgl. Anteil A_{Al} (der hier in Projektion auf einen Radiusvektor ermittelt wird). Der zentrale, zusätzliche Al-Block 33 trägt ebenfalls zur Gewichtsreduktion und zur Stabilisierungsfunktion bei.

Man beachte, dass allgemein nach Zusammensetzen einer Supraleiterdrahtstruktur gemäß der Erfindung mit Al-Blöcken und NbTi-haltigen Sektionen bevorzugt keine Wärmebehandlungen über 200°C mehr erfolgen, um die Bildung von spröden intermetallischen Phasen aus Cu und Al zu vermeiden. Typischerweise erfolgen dann nur noch Kaltverformungen (soweit gewünscht). Das NbTi-Supraleitermaterial im Supraleiterdraht ist bevorzugt vom Typ "artificial pinning".

## Patentansprüche

1. Supraleiterdraht (1; 31), enthaltend NbTi-Supraleitermaterial und Cu, mit
- mit mindestens drei Al-Blöcken (3a-3c), die in Umfangsrichtung verteilt angeordnet sind,
- und mit mindestens drei NbTi-haltigen Sektionen (4a-4c), die ebenfalls in Umfangsrichtung verteilt angeordnet sind, und die die Al-Blöcke (3a-3c) in Umfangsrichtung voneinander trennen,
**dadurch gekennzeichnet,**
**dass** der Supraleiterdraht (1; 31) weiterhin aufweist
- ein Hüllrohr (2), insbesondere ein Cu-Hüllrohr,
wobei die mindestens drei Al-Blöcke (3a-3c) in Umfangsrichtung verteilt im Hüllrohr (2) angeordnet sind,
und wobei die mindestens drei NbTi-haltigen Sektionen (4a-4c) in Umfangsrichtung verteilt im Hüllrohr (2) angeordnet sind,
**dass** die Al-Blöcke (3a-3c) jeweils flächig an ihren benachbarten NbTi-haltigen Sektionen (4a-4c) anliegen, wobei ein flächiger Kontakt zwischen den NbTi-haltigen Sektionen (4a-4c) und den Al-Blöcken (3a-3c) im Querschnitt über wenigstens 20% des Drahtdurchmessers an näherungsweise in radialer Richtung verlaufenden Grenzflächen von NbTi-haltigen Sektionen (4a-4c) und Al-Blöcken (3a-3c) besteht,
und **dass** der Supraleiterdraht (1: 31) lotfrei ausgebildet ist.

2. Supraleiterdraht (1; 31) nach Anspruch 1, **dadurch gekennzeichnet, dass** die NbTi-haltigen Sektionen (4a-4c) durch einen oder mehrere tieflochgebohrte Cu-Blöcke (6; 6a-6c) ausgebildet sind, wobei NbTi-Strukturen (8), die jeweils ein oder mehrere NbTi-Filamente enthalten, in Bohrungen (7) des einen oder der mehreren Cu-Blöcke (6; 6a-6c) eingefügt sind.

3. Supraleiterdraht (1; 31) nach Anspruch 2, **dadurch gekennzeichnet, dass** die NbTi-haltigen Sektionen (4a-4c) durch nur einen tieflochgebohrten Cu-Block (6) ausgebildet sind, wobei der Cu-Block (6) wenigstens drei radial einwärts ausgebildete Nuten (10) aufweist, die jeweils einen Al-Block (3a-3c) enthalten.

4. Supraleiterdraht (1; 31) nach Anspruch 2, **dadurch gekennzeichnet, dass** die NbTi-haltigen Sektionen (4a-4c) jeweils durch einen tieflochgebohrten Cu-Block (6a-6c) ausgebildet sind, und dass ein zentrales Cu-Profilrohr (11) vorgesehen ist, an welches die Al-Blöcke (3a-3c) und die Cu-Blöcke (6a-6c) angrenzen, wobei das Profilrohr (11) einen zusätzlichen Al-Block (12) enthält.

5. Supraleiterdraht (1; 31) nach Anspruch 1, **dadurch gekennzeichnet, dass** die NbTi-haltigen Sektionen (4a-4c) jeweils als ein Cluster (34a-34c) von aneinander angrenzenden NbTi-Hexagonalelementen (35), welche jeweils ein oder mehrere NbTi-Filamente enthalten, ausgebildet sind.

6. Supraleiterdraht (1; 31) nach Anspruch 5, **dadurch gekennzeichnet, dass** ein zentrales Cu-Profilrohr (32) vorgesehen ist, an welches die Al-Blöcke (3a-3c) und die Cluster (34a-34c) angrenzen, wobei das Profilrohr (32) einen zusätzlichen Al-Block (33) enthält, und wobei das Cu-Profilrohr (32) eine äußere Profilierung (32a) geeignet für die Anlage der NbTi-Hexagonalelemente (35) aufweist,
insbesondere wobei das Cu-Profilrohr (32) eine allseitige äußere Profilierung (32a) aufweist.

7. Supraleiterdraht (1; 31) nach Anspruch 5 oder 6, **dadurch gekennzeichnet, dass** das Hüllrohr (2) mehrere Cu-Füllplatten (36) enthält, wobei die Cu-Füllplatten (36) eine Profilierung geeignet für eine Anlage der NbTi-Hexagonalelemente (35) der Cluster (34a-34c) aufweisen.

8. Supraleiterdraht (1; 31) nach einem der Ansprüche 5 bis 7, **dadurch gekennzeichnet, dass** die Al-Blöcke (3a-3c) eine Profilierung geeignet für die Anlage der NbTi-Hexagonalelemente (35) der Cluster (34a-34c) aufweisen, insbesondere wobei die Al-Blöcke (3a-3c) eine allseitige Profilierung aufweisen.

9. Supraleiterdraht (1; 31) nach einem der vorhergehenden Ansprüche, **dadurch gekennzeichnet, dass** genau N Al-Blöcke (3a-3c) vorgesehen sind, die in Umfangsrichtung verteilt im Hüllrohr (2) angeordnet sind, und dass genau N NbTi-haltige Sektionen (4a-4c) vorgesehen sind, die ebenfalls in Umfangsrichtung verteilt im Hüllrohr (2) angeordnet sind, und die die Al-Blöcke (3a-3c) in Umfangsrichtung voneinander trennen, wobei N = 3, 4, 5 oder 6.

10. Supraleiterdraht (1; 31) nach einem der vorhergehenden Ansprüche, **dadurch gekennzeichnet, dass** der Supraleiterdraht (1; 31) einen kreisrunden Querschnitt aufweist.

11. Supraleiterdraht (1; 31) nach einem der vorhergehenden Ansprüche, **dadurch gekennzeichnet, dass** der Supraleiterdraht (1; 31) im Querschnitt ohne Hohlräume ausgebildet ist.

12. Supraleiterdraht (1; 31) nach einem der vorhergehenden Ansprüche, **dadurch gekennzeichnet, dass** die Al-Blöcke (3a-3c) direkt an das Hüllrohr (2) angrenzen.

## Claims

1. Superconducting wire (1; 31), comprising NbTi superconducting material and Cu, with
- with at least three Al blocks (3a-3c), which are disposed peripherally distributed,
- and with at least three sections (4a-4c) containing NbTi, which are also disposed peripherally distributed and separate the Al blocks (3a-3c) from one another in the peripheral direction, **characterized in that**
the superconducting wire (1; 31) moreover comprises
- an enclosing tube (2), in particular, a Cu enclosing tube,
wherein the at least three Al blocks (3a-3c) are disposed peripherally distributed in the enclosing tube (2),
and wherein the at least three sections (4a-4c) containing NbTi are disposed peripherally distributed in the enclosing tube (2),
that the Al blocks (3a-3c) each make large-surface contact with their adjacent sections (4a-4c) containing NbTi, wherein flat contact is provided between the sections (4a-4c) containing NbTi and the Al blocks (3a-3c) through, in cross section, at least 20% of the diameter of the wire at bordering surfaces between the sections (4a-4c) containing NbTi and the Al blocks (3a-3c), which extend approximately in the radial direction, and that the superconducting wire (1; 31) contains no solder.

2. Superconducting wire (1; 31) according to claim 1, **characterized in that** the sections (4a-4c) containing NbTi are constituted by one or more deep-hole drilled Cu blocks (6; 6a-6c), wherein NbTi structures (8), which in each case contain one or more NbTi filaments, are inserted into holes (7) of said one or more Cu blocks (6; 6a-6c).

3. Superconducting wire (1; 31) according to claim 2, **characterized in that** the sections (4a-4c) containing NbTi are constituted by only one deep-hole drilled Cu block (6), wherein the Cu block (6) has at least three grooves (10) extending radially inward, each of which contains one Al block (3a-3c).

4. Superconducting wire (1; 31) according to claim 2, **characterized in that** the sections (4a-4c) containing NbTi are each constituted by one deep-hole drilled Cu block (6a-6c), and that one central Cu shaped tube (11) is provided, with which the Al blocks (3a-3c) and the Cu blocks (6a-6c) are contiguous, wherein the shaped tube (11) comprises an additional Al block (12).

5. Superconducting wire (1; 31) according to claim 1, **characterized in that** the sections (4a-4c) containing NbTi are each constituted as a cluster (34a-34c) of contiguous NbTi hexagonal elements (35), each of which contains one or more NbTi filaments.

6. Superconducting wire (1; 31) according to claim 5, **characterized in that** a central Cu shaped tube (32) is provided with which the Al blocks (3a-3c) and the clusters (34a-34c) are contiguous, wherein the Cu shaped tube (32) comprises an additional Al block (33), and wherein the Cu shaped tube (32) has exterior shaping (32a), suitable for positioning the NbTi hexagonal elements (35),
in particular wherein the Cu shaped tube (32) is shaped all around its circumference (32a).

7. Superconducting wire (1; 31) according to claim 5 or 6, **characterized in that** the enclosing tube (2) contains multiple Cu filler plates (36), wherein the Cu filler plates (36) are shaped in a way that is suitable for positioning the NbTi hexagonal elements (35) of the clusters (34a-34c).

8. Superconducting wire (1; 31) according to any one of the claims 5 to 7, **characterized in that** the Al blocks (3a-3c) are shaped in a way that is suitable for positioning the NbTi hexagonal elements (35) of the clusters (34a-34c), in particular wherein the Al blocks (3a-3c) are shaped all around their circumference.

9. Superconducting wire (1; 31) according to any one of the previous claims, **characterized in that** exactly N Al blocks (3a-3c) are provided, which are disposed peripherally distributed in the enclosing tube (2), and that precisely N sections (4a-4c) containing NbTi are provided, which are also disposed peripherally distributed in the enclosing tube (2), and which separate the Al blocks (3a-3c) from one another peripherally, wherein N = 3, 4, 5 or 6.

10. Superconducting wire (1; 31) according to any one of the previous claims, **characterized in that** the superconducting wire (1; 31) has a circular cross-section.

11. Superconducting wire (1; 31) according to any one of the previous claims, **characterized in that** the superconducting wire (1; 31) has a cross section without cavities.

12. Superconducting wire (1; 31) according to any one of the previous claims, **characterized in that** the Al blocks (3a-3c) directly border the enclosing tube (2).

## Revendications

1. Fil supraconducteur (1 ; 31) contenant du matériau supraconducteur NbTi et du Cu,
- avec au moins trois blocs d'Al (3a-3c) qui sont répartis en direction circonférentielle,
- et avec au moins trois sections (4a-4c) contenant du NbTi qui sont également réparties en direction circonférentielle et qui séparent les blocs d'Al (3a-3c) les uns des autres en direction circonférentielle,
**caractérisé en ce**
**que** le fil supraconducteur (1 ; 31) présente en outre
- un tube enveloppe (2), en particulier un tube enveloppe en Cu,
lesdits au moins trois blocs d'Al (3a-3c) étant répartis en direction circonférentielle dans le tube enveloppe (2),
et lesdites au moins trois sections (4a-4c) contenant du NbTi étant réparties en direction circonférentielle dans le tube enveloppe (2),
**que** les blocs d'Al (3a-3c) sont chacun appliqués à plat contre les sections (4a-4c) contenant du NbTi qui leur sont adjacentes, un contact plat entre les sections (4a-4c) contenant du NbTi et les blocs d'Al (3a-3c) existant en section transversale sur au moins 20 % du diamètre du fil à des surfaces limites s'étendant approximativement en direction radiale des sections (4a-4c) contenant du NbTi et des blocs d'Al (3a-3c),
et **que** le fil supraconducteur (1 ; 31) est réalisé sans métal d'apport de brasage.

2. Fil supraconducteur (1 ; 31) selon la revendication 1, **caractérisé en ce que** les sections (4a-4c) contenant du NbTi sont formés par un ou plusieurs blocs de Cu (6 ; 6a-6c) à perçages profonds, des structures en NbTi (8), qui contiennent chacune un ou plusieurs filaments de NbTi, étant insérées dans des perçages (7) desdits un ou plusieurs blocs de Cu (6 ; 6a-6c) à perçages profonds.

3. Fil supraconducteur (1 ; 31) selon la revendication 2, **caractérisé en ce que** les sections (4a-4c) contenant du NbTi sont formées par seulement un bloc de Cu (6) à perçages profonds, le bloc de Cu (6) présentant au moins trois rainures (10) formées radialement vers l'intérieur, qui contiennent chacune un bloc d'Al (3a-3c).

4. Fil supraconducteur (1 ; 31) selon la revendication 2, **caractérisé en ce que** les sections (4a-4c) contenant du NbTi sont formées chacune par un bloc de Cu (6) à perçages profonds (6a-6c), et qu'un tube profilé central en Cu (11) est prévu, auquel les blocs d'Al (3a-3c) et les blocs de Cu (6a-6c) sont adjacents, le tube profilé (11) contenant un bloc d'Al supplémentaire (12).

5. Fil supraconducteur (1 ; 31) selon la revendication 1, **caractérisé en ce que** les sections (4a-4c) contenant du NbTi sont réalisées chacune sous la forme d'une grappe (34a-34c) d'éléments hexagonaux en NbTi (35) adjacents les uns aux autres, lesquels contiennent chacun un ou plusieurs filaments de NbTi.

6. Fil supraconducteur (1 ; 31) selon la revendication 5, **caractérisé en ce qu'**un tube profilé central en Cu (32) est prévu, auquel les blocs d'Al (3a-3c) et les grappes (34a-34c) sont adjacents, le tube profilé (32) contenant un bloc d'Al supplémentaire (33) et le tube profilé en Cu (32) présentant un profilage extérieur (32a) adapté au contact avec les éléments hexagonaux en NbTi (35),
le tube profilé en Cu (32) présentant en particulier un profilage extérieur (32a) de tous les côtés.

7. Fil supraconducteur (1 ; 31) selon la revendication 5 ou 6, **caractérisé en ce que** le tube enveloppe (2) contient plusieurs plaques de remplissage en Cu (36), les plaques de remplissage en Cu (36) présentant un profilage adapté au contact avec les éléments hexagonaux en NbTi (35) des grappes (34a-34c).

8. Fil supraconducteur (1 ; 31) selon l'une des revendications 5 à 7, **caractérisé en ce que** les blocs d'Al (3a-3c) présentent un profilage adapté au contact avec les éléments hexagonaux en NbTi (35) des grappes (34a-34c), les blocs d'Al (3a-3c) présentant en particulier un profilage de tous les côtés.

9. Fil supraconducteur (1 ; 31) selon l'une des revendications précédentes, **caractérisé en ce qu'**exactement N blocs d'Al (3a-3c) sont prévus, qui sont répartis en direction circonférentielle dans le tube enveloppe (2), et qu'exactement N sections (4a-4c) contenant du NbTi sont prévues, qui sont également réparties en direction circonférentielle dans le tube enveloppe (2) et qui séparent les blocs d'Al (3a-3c) les uns des autres en direction circonférentielle, avec N = 3, 4, 5 ou 6.

10. Fil supraconducteur (1 ; 31) selon l'une des revendications précédentes, **caractérisé en ce que** le fil supraconducteur (1 ; 31) présente une section transversale circulaire.

11. Fil supraconducteur (1 ; 31) selon l'une des revendications précédentes, **caractérisé en ce que** le fil supraconducteur (1 ; 31) est réalisé sans espaces vides en section transversale.

12. Fil supraconducteur (1 ; 31) selon l'une des revendications précédentes, **caractérisé en ce que** les blocs d'Al (3a-3c) sont directement adjacents au tube enveloppe (2).
